Europäisches Patentamt

European Patent Office

Office européen des brevets

(11) Publication number: **0 261 954 B1**

# EUROPEAN PATENT SPECIFICATION

(45) Date of publication of patent specification: **30.03.94**

(51) Int. Cl.⁵: **H03G 3/00**, H03G 7/00, G06F 7/52

(21) Application number: **87308428.9**

(22) Date of filing: **23.09.87**

(54) **Digital signal gain control circuitry.**

(30) Priority: **24.09.86 US 910993**
**11.05.87 US 48427**

(43) Date of publication of application:
**30.03.88 Bulletin 88/13**

(45) Publication of the grant of the patent:
**30.03.94 Bulletin 94/13**

(84) Designated Contracting States:
**AT DE ES FR GB IT SE**

(56) References cited:
**DE-A- 2 346 188**
**GB-A- 2 035 732**
**US-A- 4 004 140**
**US-A- 4 287 805**

(73) Proprietor: **RCA Thomson Licensing Corporation**
**2 Independence Way**
**Princeton New Jersey 08540(US)**

(72) Inventor: **Christopher, Todd J.**
**1402 South Kitley Avenue**
**Indianapolis Indiana(US)**
Inventor: **Dieterich, Charles Benjamin**
**7 Euclid Avenue**
**Kingston New Jersey(US)**

(74) Representative: **Pratt, Richard Wilson et al**
**London Patent Operation**
**G.E. Technical Services Co. Inc.**
**Essex House**
**12/13 Essex Street**
**London WC2R 3AA (GB)**

## EP 0 261 954 B1

**Description**

This invention relates to circuitry for scaling bit-serial signals by constant multiplier factors, such as can be used for volume control in a digital audio signal reproduction system.

It is known from DE-A-23 46 188 to provide a digital circuit including a shift register for a bit-serial multiplication. The shift register has output taps which correspond to the desired multiplicand.

It is known from GB-A-2035732 to provide a serial combination of an analog coarse control means and a digital fine control means operated in response to signals generated by a control signal generator.

Multiplication or scaling of signals represented in binary form may be accomplished by a method of shifting and adding the signal sample to itself. In performing multiplication by this technique the binary samples are coupled to circuitry which shifts the bit positions of the sample bits relative to the binary point of the sample. This circuitry will provide one or more bit shifted versions of the input sample depending upon the desired multiplication factor. The bit shifted samples are additively or subtractively combined with the input sample. The combined sample corresponds to the input sample multiplied by the desired multiplication factor.

Consider a binary sample having consecutive bits ordered from left to right with the leftmost bit being the most significant bit (MSB) and the rightmost bit being the least significant bit (LSB). Assume that the sample has a binary point located immediately to the right of the LSB. Shifting all of the bits of the sample rightward with respect to the binary point effectively divides the sample by the factor of two for each bit position the sample bits are shifted. Alternatively shifting all of the bits of the sample leftward, effectively multiplies the sample by the factor of two for each bit position the sample bits are shifted. For example, the decimal value 14 is represented 1110 in binary. Shifting all of the bits of the sample rightward one and two bit positions relative to the binary point produces the binary samples 0111.0 and 0011.1 respectively. The decimal values of these shifted samples are 7 and 3.5 respectively corresponding to the original sample divided by two and four. In general, bit shifting a binary sample by n-bit positions relative to the binary point rightward or leftward effects a division or multiplication of the sample by a factor of $2^n$ respectively. Now if the two shifted binary samples and the original sample in the foregoing example are additively combined the resulting binary sample will equal 11000.1 or 24.5 decimal. This represents a scaling of the original sample by a factor of 1 + 1/2 + 1/4 or 7/4. Alternatively if the shifted samples 0111.0 and 0011.1 are additively combined with the original sample with positive and negative polarities respectively, the resulting binary sample is 10001.1 or 17.5 decimal. This value represents a scaling of the original sample by 1 + 1/2 -1/4 or 5/4. Depending upon the number of shifted versions of the original sample that are combined, the number of bit positions that each of the shifted versions have been shifted relative to the original sample, and the polarity with which the signals are combined, a wide range of scale factors may be realized with this shifting and adding technique.

The shifting and adding technique is particularly conducive to scaling parallel-bit binary samples by constant multiplying factors. In parallel-bit systems all of the bits of a sample occur concurrently on respective ones of parallel output connections of a parallel bus structure. Each of the output connections is assigned a bit position or significance. Bit shifting is accomplished simply by appropriately connecting the input busses of circuit elements to the parallel output connections. Assume that the output connections are designated, in order of significance, $2^n$, $2^{n-1}$, ...$2^1$, $2^0$ and that the input connections of a circuit element, to which a bit shifted sample is to be applied, are designated, in order of significance $2^w$, $2^{w-1}$...$2^1$, $2^0$, where n and w are integers and n equals w. Connecting the input connections $2^w$, $2^{w-1}$...$2^1$, $2^0$ to the output connections $2^n$, $2^{n-1}$,...$2^1$, $2^0$ respectively corresponds to a zero bit shift, i.e. the samples applied to the input connection are unaltered. Connecting the input connections $2^w$, $2^{w-1}$...$2^3$, $2^2$ to the output connections $2^{n-2}$, $2^{n-3}$,...$2^0$, $2^1$ provides a leftward bit shift of two bit positions. In this instance the two LSB input connections $2^1$, $2^0$ are coupled to a logic zero potential. Connecting the input connections $2^w$, $2^{w-1}$ to logic zero potential and input connections $2^{w-2}$, $2^{w-1}$...$2^3$, $2^2$, to output connections $2^n$, $2^{n-1}$...$2^3$, $2^2$ respectively effects a rightward shift of two bit positions.

Using the foregoing bit shifting method, a parallel-bit system for multiplying binary samples by a constant scale factor may be realized by coupling combining elements (adders and subtractors) with their input connections appropriately shifted with respect to the output connections of the source providing the samples to be scaled.

Heretofore the shifting and adding technique for scaling binary samples has had little application to bit-serial processing. The sample bits of bit-serial samples occur sequentially in time. Nominally the LSB occurs first in the sequence to facilitate sample processing. A bit shifted version of a bit-serial sample is developed by delaying the bit-serial sample by integral bit periods.

2

For each bit-period the sample is delayed, the sample is effectively left shifted one significant bit position relative to the original sample. As indicated previously leftward shifting the sample bits provides multiplication of the sample by powers of two. Right shifting of bit-serial samples implies providing versions of a sample advanced in time, that is providing a sample before it occurs. In general, this is not possible but a similar result can be accomplished by reordering the bit-serial samples so that the MSB occurs first in time and the LSB last in time. Delaying the reordered samples by integral bit periods effectively provides a rightward shift of the sample bits. For each bit period the reordered sample is delayed, it is divided by the factor two relative to the undelayed sample.

Bit-serial systems for scaling bit-serial samples by constant factors, other than simple powers of two or simple reciprocal powers of two, may be realized by arranging a system of parallel connected bit-serial delaying elements for delaying the bit-serial samples by different integral numbers of bit-periods and combining the delayed samples. Such a system requires an unnecessary amount of hardware particularly if circuitry is included to reorder the sample sequence to perform sample division.

Developments in digital processing circuitry have made practical consumer digital audio systems. Digital audio systems are desirable because of their inherent parametric stability, high signal-to-noise qualities and reduced parts count.

The input and output of digital audio systems are analog. At the input end of the digital system the analog sound signal is converted to digital representations of the analog signal and at the output end the processed digital representations are reconverted to analog form for application to speakers. It is desirable that volume control of the audio signal be performed in the digital domain to eliminate noise associated with analog control potentiometers and analog switched gain elements. In addition, using large scale integrated circuitry, an entire digital audio processing system, including volume control can be fabricated on a single integrated circuit, and all control functions can easily be effected from, for example, a remote transmitter.

According to the present invention, there is provided a bit-serial signal scaling apparatus (20') for scaling bit-serial signals by a constant factor characterized by: means including a cascade connection of signal combining circuits (60,62,66) each in the form of an adder element (60,62) or a subtracter element (66), extending from a bit-serial signal input terminal, said signal combining circuits having respective first input terminals and output terminals coupled in said cascade connection wherein a delay (58,64) of at least one bit period is provided by or between ones of said signal combining circuits, said signal combining circuits having respective second input terminals; and means (68,70,72,74) for selectively coupling said signal input terminal to said second input terminals of said signal combining circuits.

An embodiment of the present invention provides a versatile, parts efficient, bit-serial binary signal scaling system for providing scaled representations of an applied bit-serial signal. A first plurality of signal combining circuits, each in the form of an adder circuit or a subtracter circuit, having respective first and second input terminals and having respective output terminals, and a plurality of delay circuits for delaying bit-serial signals by signal bit periods are cascade connected, with ones of the delay circuits disposed between ones of the combining circuits. First input terminals of the combining circuits are coupled to the respective output terminals of either a preceding delay circuit or a preceding combining circuit in the cascade connection and respective second input terminals of the combining circuits are coupled to receive the signal to be scaled. The output of the cascade connection of delay and signal combining circuits is a scaled version of the applied signal.

In the accompanying drawings:

FIGURES 1, 3 and 4 are block diagrams of a bit-serial digital processing circuit useful in describing a bit-serial system in which the present invention may be utilized.

FIGURE 2 is a clock timing-waveform diagram illustrating system timing for bit-serial processors of the type illustrated in FIGURES 1, 3 and 4 and which may be used in timing the present invention.

FIGURE 5 is a block diagram of a digital audio system including a digital volume control system embodying the invention.

FIGURES 6, 8 and 9 are partial block - partial logic schematic diagrams of serial-bit digital volume control systems embodying the invention.

FIGURE 7 is a timing diagram useful in describing the serial-bit systems of FIGURES 6, 8 and 9.

FIGURE 10 is a block diagram of a parallel-bit digital volume control system embodying the invention.

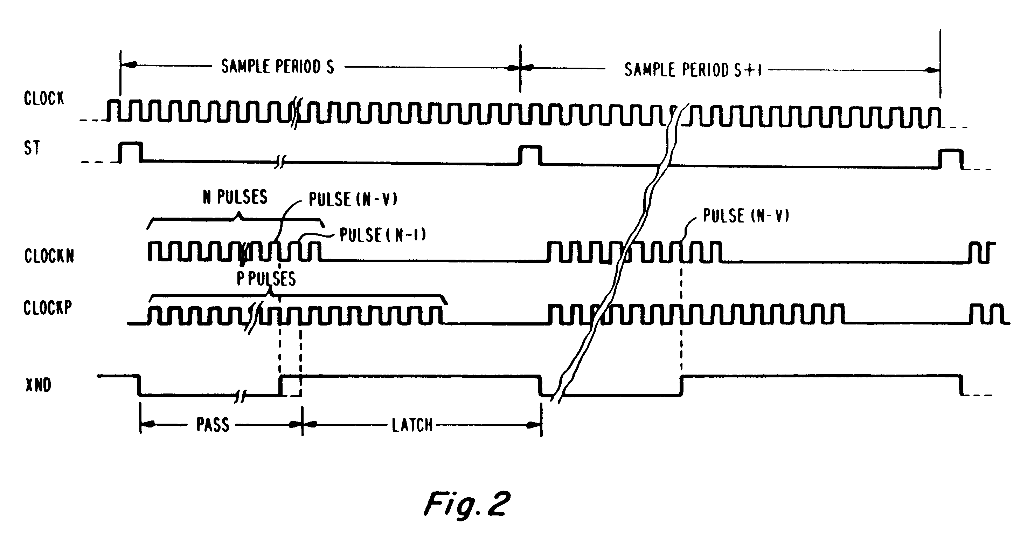

A bit-serial system, in which the invention may be used, will first be discussed to provide a basis for understanding the invention. The system utilizes a gated clock approach to processing bit-serial samples. The gated clock approach is described with reference to FIGURE 2. The waveform ST defines a sample processing period. Successive samples to be processed occur during successive cycles of waveform ST. The respective bits of each bit-serial sample occur synchronously with pulses of the system clock defined by the waveform designated CLOCK. In general the number of bits included in a sample are less than the number of cycles of the system clock in each sample period.

At the beginning of each sample period, respective samples in the system are clocked concurrently to processing elements under the control of a gated clock designated in FIGURE 2 as CLOCK N. The number of pulses, N, contained in each burst of pulses provided by CLOCK N is at least as large as the number of bits of the largest sample to be processed. Thus, CLOCK N determines the dynamic range of the system. Individual processing elements within the system operate synchronously with the system clock, CLOCK, but may be energized by either CLOCK N, CLOCK P or CLOCK, depending on the timing requirements to accomplish its function. At the end of each sample period, each processing element will have completed processing the sample provided thereto, and have arranged the sample for transference to a subsequent processing element at the beginning of the next sample period.

The samples are assumed to be in two's complement format. In addition, sample bits are arranged such that the LSB's occur first in time and the remaining bits occur in ascending order of significance.

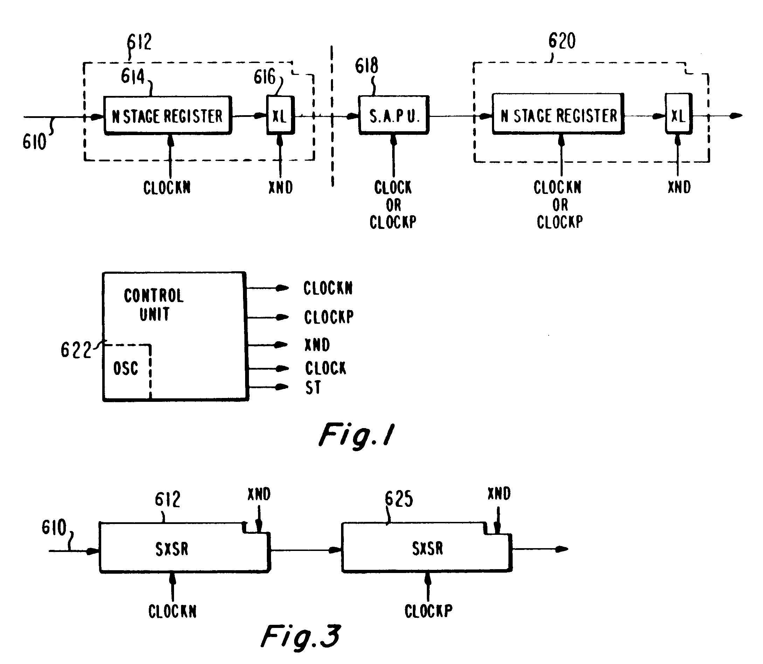

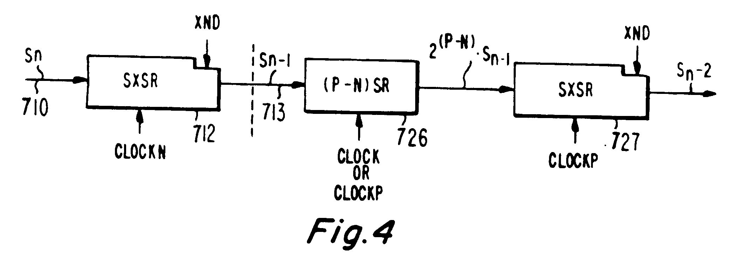

The system will be more particularly described with reference to the circuitry illustrated in FIGURES 1, 3 and 4 in conjunction with the waveforms illustrated in FIGURE 2. The circuit elements of FIGURES 3 and 4 are selected for enabling an understanding of how multiplication and division by powers of two is accomplished in the gated clock system. This provides a basis for understanding the bit-serial scaling circuitry embodying the invention.

In FIGURE 1, bit-serial digital samples to be processed are applied at terminal 610. The sample is synchronously clocked into the N-stage serial shift register 614 under the control of the clock signal, CLOCK N, having N clocking pulses. The first clock pulse is synchronized to occur coincidently with the first or least significant sample bit. The sample bits are clocked into the N-V least significant bit positions of register 614, that is, into the register stages closest to the register output connection. At the end of the $N^{th}$ clock pulse of CLOCK N, CLOCK N is halted and the sample is stored in the register until the next sample period.

A sample space of N-bit periods is provided, but in general, respective samples within a system may contain fewer than N bits. In this instance, the sample is represented by (N-V) bits where N and V are both integers.

The value of V may be different in different parts of a given system because the maximum possible values of the samples may change as they are processed, and therefore, the number of bits required to define the sample value will change. For example, assume N is equal to 20 and samples having a maximum value of 16384 are applied to a doubling circuit. At the input to the doubling circuit (N-V) is 14 but at the output of the doubling circuit (N-V) must be increased to 15, and consequently V changes from 6 to 5.

The N-V information bits of each bit-serial sample occur, seriatim, from least significant bit (LSB) to most significant bit (MSB). The extra V bit spaces are appended to the MSB end of each sample to absorb changing bit widths of processed samples. The samples are presumed to be in two's complement format with the $(N-V)^{th}$ bit representing the sign bit. In order to efficiently process two's complement samples, the sign bit is traditionally constrained to occupy the MSB position of each respective sample space, i.e. the Nth bit period. This condition is achieved in the present invention by replicating the $(N-V)^{th}$ sign bit in each of the V bit positions. An N-bit sample having V extra MSB's replicating the $(N-V)^{th}$ sign bit of a sample with (N-V) bit resolution has the same numeric value as an (N-V) bit sample.

Sign bit replication is accomplished by connecting a sign extension latch, 616, in series with the output terminal of register 614. Latch 616 is conditioned by a control signal XND to pass the first N-V-1 sample bits output by register 614 and to latch and hold the $(N-V)^{th}$ sample bit (the sign bit) for the remainder of the sample period. Latch 616 may be of the type designated SN74LS75 "Bistable Latches" available from Texas Instruments Inc., Dallas, Texas. The timing of the control signal XND applied to latch 616 relative to the clock pulses provided by CLOCK N is illustrated in FIGURE 2.

Since latch 616 holds the $(N-V)^{th}$ sample bit for the remainder of the sample period, the values stored in the V MSB positions of register 612 are immaterial because they are precluded from exiting register 614. Note, however, that if the sign bit of the (N-V) bit sample in register 614 had initially been replicated in the V MSB positions of the sample bit space, then the onset of the control signal may be delayed to the (N-1)st clock pulse of CLOCK N. In this instance the number of bits defining the sample resolution may change to greater or lesser numbers but the leading edge of the control pulse XND can be held constant at clock pulse (N-1).

Nominally, the positive going transition of the signal XND will be generated to occur immediately after the clock pulse corresponding to the most significant value bit position of the sample having the least number of value bits in a given system. To accommodate samples defined with a greater number of bits processed by similar circuits in the system, the positive going transition of signal XND is delayed by the appropriate number of clock periods by, for example, flip-flop stages. For the remainder of the discussion, it will be presumed that the maximum sample values are represented by N bits with the Nth bit being the sign bit. The signal XND is therefore generated by the control unit to occur after the (N-1)st clock pulse.

The combination of the register 614 and latch 616 will subsequently be designated a sign-extend-shift-register, SXSR. Its output is coupled to a serial arithmetic processing unit, or SAPU, 618, externally clocked (as indicated) or self-clocked, whose output is coupled to a further SXSR 620. The SAPU 618 in general will not contain sample storage so SXSR 620 is provided to accept the sample bits as they are processed and to store the processed bits until the next sample period. If the SAPU 618 processes samples without delay, that is, the processing of a respective bit is completed within its corresponding clock period, SXSR 620 will be clocked by CLOCK N. Alternatively, if the processed bits incur bit-time delays in being processed in SAPU 618, SXSR 620 must be clocked by more than N pulses to properly right justify or time align the sample bits in the register for the next sample period.

Consider that the sample bits incur a delay of M clock pulse periods in being processed in SAPU 618. In order for the LSB of the processed sample to be registered in the LSB position of the N stage SXSR 620 upon completion of processing the respective sample, to be properly justified at the beginning of the next sample period, SXSR 620 must be clocked with $N+M$ clock pulses. In FIGURES 1 and 2 CLOCK P provides the appropriate numbers of pulses.

In general, CLOCK P provides a number of pulses per sample period to accommodate the particular SAPU in the system, which has the greatest processing delay. Additional register stages are coupled between other SAPU's (having lesser processing delays) and their corresponding SXSR's so that a common clock signal CLOCK P may be utilized for at least a majority of processing circuits having processing delays. The number of additional register stages are selected so that the processing delay (in clock pulse periods) plus the additional stages plus N equals the number P.

The apparatus in FIGURE 1 includes an SXSR at the input and output of the processing element 618. In general, SXSR 612 will be associated with a preceding processing stage and it is not intended to be implied that an arithmetic processing element requires both an input and an output SXSR. In fact, certain processing functions may be serially concatenated without intervening SXSR's.

The system clocks and/or control signals are generated in the control unit 622. Control unit 622 may include an oscillator from which the master clock, CLOCK, is derived. CLOCK N, CLOCK P, sample signal ST and the sign extend control signal XND may all be derived from the master clock signal by conventional counting and gating circuits. Such signals may be generated by conventional techniques knowing the relationships illustrated in FIGURE 2.

FIGURE 3 illustrates circuitry to multiply a serial sample by a constant value equal to $2^{-(P-N)}$. Shifting all the bits of a binary sample to one bit position of lesser significance effects a multiplication of the sample by a factor of $\frac{1}{2}$. Shifting all the bits of a sample to N-bit positions of lesser significance effects a scaling or multiplication by $2^{-N}$ and shifting the bits to (P-N) bit positions of lesser significance effects a multiplication by $2^{-(P-N)}$. Assume that at the beginning of a sample period register 612 contains an N-bit sample. Assume also that SXSR registers 612 and 625 have N stages. SXSR 612 is clocked by CLOCK N and SXSR 625 is clocked by CLOCK P with P>N. After N clock pulses the N-bit sample in SXSR 612 has been transferred into the N stages of SXSR 625. However, CLOCK P continues to run, clocking the sample further through SXSR 625. P-N lesser significant bits of the sample are lost off the right end of SXSR 625. At the end of the burst of CLOCK P pulses, the 2N-P more significant bits of the original N-bit sample occupy the 2N-P LSB positions of register 625. The P-N MSB positions of register 625 are loaded with the replicated sign-bit of the sample from register 612. The value of the sample in register 625 is $2^{-(P-N)}$ times the value of the original N-bit sample due to the change in bit significance. The sign extend latch of register 625 is energized after N-1 clock pulses to replicate the sign bit of the sample stored in register 625 during the previous sample period, and to excise the P-N LSB's of the current sample from register 612. For practical implementations of this circuit the number of clock pulses of clock P minus the number of clock pulses of CLOCK N must be less than the number of bits defining the resolution of the original samples or else the shifted samples will be rendered equal to a value of zero or the smallest negative number realizable.

FIGURE 4 illustrates apparatus for delaying a sample by one sample period. The circuit consists of the cascade connection of an SXSR 712, a (P-N)-stage shift register 726 and SXSR 727. The number of stages (P-N) is equal to the difference in the number of pulses between CLOCK P and CLOCK N. The number of stages in each of registers 712 and 727 are assumed to be N. The number of stages in the combined registers 726 and 727 is equal to $(P-N)+N$ or P stages. Consequently, P clock pulses are required to clock the LSB from SXSR 712 into the LSB position of SXSR 727. This is precisely the number of pulses occurring in a burst of CLOCK P pulses in each sample period. Thus, registers 726 and 727 provide a delay of one sample period if register 727 is clocked by CLOCK P. Register 726 may be clocked continuously by the master clock, CLOCK. An N-stage SXSR substituted for registers 726 and 727 and clocked by CLOCK N will also effect a one sample period delay for a bit-serial sample.

Next consider that registers 726 and 727 are clocked by CLOCK N. In this instance, at the end of the burst of N pulses provided by CLOCK N, the LSB of the sample from SXSR 712 will be in the (P-N)th LSB position of register 727. Essentially, all of the bits of the sample have been shifted to (P-N) more significant bit positions. This shift in bit position significance is equivalent to a multiplication of the sample by $2^{(P-N)}$. In other words, relative to the sample input to the delay register 726, the output of delay register 726 is $2^{(P-N)}$ times its input. Thus, multiplication by multiples of two may be performed by interposing register stages in the signal processing path and division by multiples of two may be performed by adding clock pulses to, for example, the clock signal of a register.

With the foregoing system information as a background, illustrative embodiments of the invention will be described.

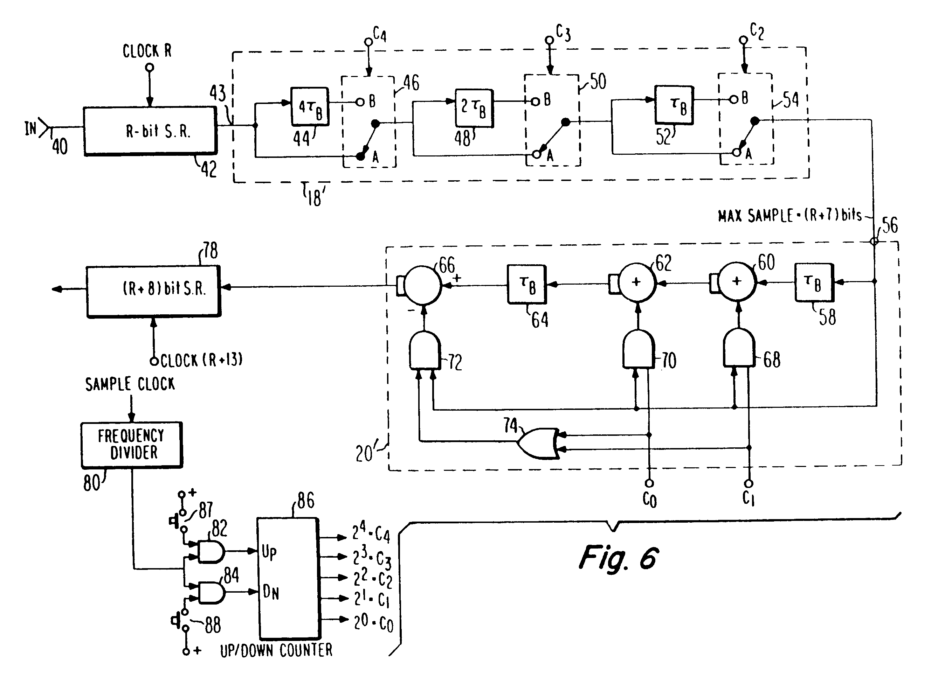

FIGURE 6 illustrates, in dotted box 20$'$, an embodiment of the invention which includes a bit-serial scaler for multiplying a bit-serial signal by a scale factor, as described above. Scaling circuits according to the invention are comprised of cascaded delay stages 58,62 and bit-serial combining circuits 60,62,66 wherein the bit-serial signals to be scaled are applied to the bit-serial combining circuits via terminal 56. The operation of this circuitry will be described in greater detail below with reference to FIGURE 6.

Volume control of digital audio signals may be accomplished by amplifying or attenuating the digital audio samples. However, it is preferable to attenuate the samples for the following reasons. Typical digital audio systems start with fourteen or sixteen bit samples in order to realize the desired dynamic range and signal to noise ratio. As the digital audio samples are processed in the digital system the sample bit-width tends to expand, to, for example, twenty bits. Consider that the 20-bit digital audio samples are to be subjected to 60 dB of volume control by amplification. This implies multiplying the samples by values from zero to 1000, and thereby increasing the maximum bit width of the 20-bit audio samples to thirty bits. If a conventional resistor ladder tree or current summing digital-to-analog converter is employed to convert the digital audio samples to the analog domain, the extra ten bits added by volume control makes the converter significantly more complicated.

Conversely if volume control is accomplished by attenuation, the maximum bit width of the processed samples remains constant at e.g. 20-bits requiring a significantly less complicated digital-to-analog converter.

It should be appreciated, however, that non-conventional digital-to-analog conversion techniques, such as pulse width modulated converters may not be complicated by extended bit widths, thus, both amplifying and attenuating volume control systems will be described.

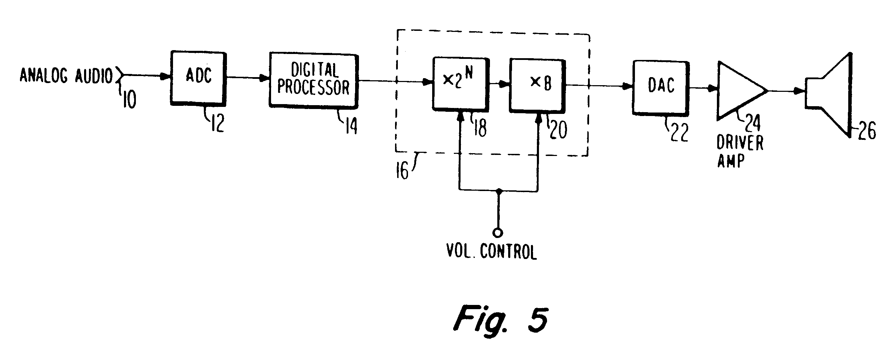

Referring to FIGURE 5, a representative digital audio processing system is shown including a digital volume control element. In FIGURE 5, an analog audio signal on connection 10, from, for example, an antenna and tuner is applied to the analog input terminal of an analog-to-digital converter (ADC) 12. ADC 12 develops pulse code modulated (PCM) representations of the analog signal at uniformly spaced time intervals and at a rate which satisfies the Nyquist sampling criterion. The PCM audio samples from ADC 12 are applied to a digital processor 14 wherein the PCM audio signal may be filtered, expanded and noise reduced or otherwise conditioned for reproduction in, for example, a speaker system.

The processed PCM audio signal from processor 14 is applied to a volume control circuit 16 which logarithmically changes the values of the PCM samples to effect amplification or attenuation of the signal. The signal from volume control circuit 16 is coupled to a digital-to-analog converter (DAC) 22 which converts the PCM audio signal to analog form. The analog signal from DAC 22 is coupled to a speaker 26 via a driver amplifier 24.

The volume control circuit 16 includes a coarse multiplier/divider 18 and a fine multiplier/divider 20. The coarse multiplier/divider 18 multiplies the applied samples by factors of $2^N$ where N represents integer values which may be positive or negative. For positive values of N, the PCM signal is multiplied by powers of two and for negative values, the PCM signal is divided by powers of two. If the value of N is incremented in unit steps the PCM signal is multiplied/divided to effect a 6 dB change per step.

The fine multiplier/divider 20 multiplies the output of the coarse multiplier/divider by a sequence of, for example, three or four numbers, which ascend/descend substantially logarithmically. If the desired volume change per step is approximately 1.5 dB the sequence of numbers, $B_i$, may be 16, 19, 23 and 27.

If the value of the signal applied to the volume control element 16 is S, the output, $O_S$, produced by element 16 in dB is

6

$$O_S = 20 \log_{10}(S \times 2^N \times B_i) \qquad (1)$$
$$= 20 \log_{10}(S) + 20 \log_{10}(2^N \times B_i). \qquad (2)$$

For a particular signal of amplitude S, changes in amplitude are governed by the term $20 \log_{10}(2^N \times B_i)$. Amplitude changes for N = -1, 0, +1 and 2 and $B_i$ 16, 19, 23 and 27 are tabulated in Table I.

TABLE I

| N | $B_i$ | $20 \log_{10}(2^N \times B_i)$ | Step dB |
|---|---|---|---|
| -1 | 16 | 18.062 | |
| -1 | 19 | 19.554 | 1.49 |
| -1 | 23 | 21.214 | 1.66 |
| -1 | 27 | 22.607 | 1.39 |
| 0 | 16 | 24.082 | 1.48 |
| 0 | 19 | 25.575 | 1.49 |
| 0 | 23 | 27.235 | 1.66 |
| 0 | 27 | 28.627 | 1.39 |
| 1 | 16 | 30.103 | 1.48 |
| 1 | 19 | 31.569 | 1.49 |
| 1 | 23 | 33.255 | 1.66 |
| 1 | 27 | 34.648 | 1.39 |
| 2 | 16 | 36.124 | 1.48 |
| 2 | 19 | 37.616 | 1.49 |
| 2 | 23 | 39.276 | 1.66 |
| 2 | 27 | 40.668 | 1.39 |

From Table I it is seen that the gain increment between recurring values of $B_i$ or for a set of values $B_i$ is approximately 6 dB. The increment or step between successive values of $B_i$ is approximately 1.5 dB and this value corresponds to the 6 dB per set of values $B_i$ divided by four, the number of values $B_i$ in the set. The gain increment per step corresponds to the difference between values $B_i$ or in dB corresponds to $20 \log_{10}(B_{i+1} - 20\log_{10}(B_i)$ which may be simplified to $20\log_{10}(B_{i+1}/Bi)$. Thus, for the set of four values of $B_i$ illustrated in Table I calculations will show that 6dB/4 approximates $20\log_{10}(B_{i+1}/B_i)$dB or more generally for any set of values of $B_i$ including P values per set (P an integer), if the gain step size is to be in substantially equal dB increments, then $20\log_{10}(B_{i+1}/B_i)$ dB must approximate 6dB/P. Taking the antilog, the ratio, $B_{i+1}/B_i$, of successive values of $B_i$ must be substantially equal to $10^{(6/20P)}$. A gain control system with approximately 2dB steps may be implemented with a fine multiplier/divider which iterates the set of three factors $B_i$ equal to 16, 20 and 25.

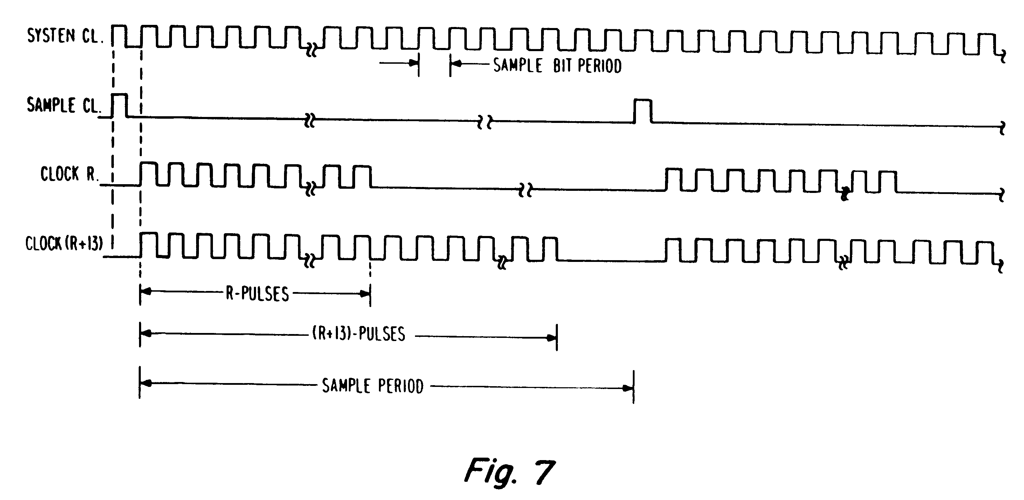

FIGURE 6 illustrates a particular serial-bit volume control circuit. This circuit will be described with reference to the waveforms illustrated in FIGURE 7. It is assumed that the serial-bit PCM samples are R-bit wide binary samples, with the least significant bit (LSB) occurring first in time. The samples occur at a rate defined by the waveform designated SAMPLE CL in FIGURE 7, which for high fidelity audio signals should be at least 44 KHz. The sample bit rate is defined by the waveform designated SYSTEM CL.

In FIGURE 6, samples from, for example the digital processor, are applied via connection 40 to an R-bit serial shift register 42. The samples are clocked into the register 42 under the control of CLOCK R having R pulses per sample period (shown as waveform CLOCK R in FIGURE 7). At the beginning of each sample period, the sample in register 42 is serially clocked out on connection 43, LSB first and a subsequent sample is loaded into the register. The samples from register 42 are coupled to the coarse multiplier/divider $18'$.

The input of multiplier/divider $18'$ is directly connected to one input terminal (designated A) of a multiplexer 46 and to a second terminal (designated B) of multiplexer 46 via a delay element 44. Delay element 44 delays samples by four sample bit rate periods and multiplexer 46 is controlled by a control signal C4.

The output of multiplexer 46 is directly coupled to input terminal A of multiplexer 50 and coupled to input terminal B of multiplexer 50 via delay element 48. Delay element 48 delays samples by two sample bit rate periods and multiplexer 50 is controlled by a control signal C3.

The output of multiplexer 50 is directly coupled to the input terminal A of multiplexer 54 and coupled to the input terminal B of multiplexer 54 via delay element 52. Delay element 52 delays samples by a one sample bit rate period and multiplexer 54 is controlled by a control signal C2.

For illustrative purposes assume that the control signals C2, C3 and C4 are each bilevel signals exhibiting logic high and logic low states. For the control signal exhibiting a logic low state, the respective multiplexer couples its output terminal to its A input terminal, and for a logic high state the respective multiplexer couples its output terminal to its B input terminal. If the control signals C2, C3 and C4 are concatenated to form the control signal C2C3C4, this signal can exhibit eight binary states representing the decimal numbers 0-7. For the concatenated control signal binary states represented by the numbers 0-7 the multiplier/divider $18'$ provides sample delays of 0-7 sample bit rate periods.

Delaying a serial-bit signal by N sample bit rate periods shifts all of the sample bits to N more significant bit positions. Shifting a serial-bit sample to N more significant bit positions effects a multiplication of the sample by $2^N$. Thus, sequencing the control signals through the states representing the numbers 0-7 multiplies the applied samples by the factors 1, 2, 4, 8, 16, 32, 64, 128. Additional stages may be added to the multiplier/divider $18'$ to provide larger binary gain factors. In dB the gain, G, of multiplier/divider $18'$ is given by

$$G = 20 \log_{10}(2^N) = N20 \log_{10}(2). \qquad (3)$$

If N is incremented by one unit, the gain is given by

$$G = (N+1)20 \log_{10}(2). \qquad (4)$$

The gain increment or step is thus 20 log = 6dB.

The output from multiplexer 54 is coupled to the input terminal 56 of the fine multiplier/divider $20'$. Multiplier/divider $20'$ includes the cascade connection of delay element 58, full adder 60, full adder 62, delay element 64 and subtracter 66. Each of the elements 58-66 impose a one sample bit rate period of delay to applied samples. The adders and subtracter are assumed to have an inherent processing delay period of one sample bit rate period. A second input to adder 60 is coupled to the input terminal 56 by an AND gate 68 which is controlled by a control signal C1. A second input to adder 62 is coupled to the input terminal 56 by an AND gate 70 which is controlled by a control signal $C_0$. The subtrahend input terminal of subtracter 66 is coupled to input terminal 56 through an AND gate 72. AND gate 72 is controlled by the logically ORed signals $C_0$ and $C_1$ provided by OR gate 74.

The output of subtracter 66 is coupled to the (R+8)-bit shift register 78 which is clocked by a clock having (R+13)-bit rate pulses (waveform CLOCK (R+13) in FIGURE 7). Register 78 has R+8 bits or stages to accommodate the product of the sample times the multiplier.

Coarse multiplier/divider $18'$ contributes 7 bits to the R-bit sample, that is, the product of an R-bit sample and a 7-bit multiplier is an (R+7)-bit sample. Fine multiplier/divider $20'$ imposes a minimum delay of 5 sample bit periods to the coarse product which, if uncompensated, causes the volume control system to have a minimum gain factor of 32. In order to normalize the minimum gain factor to a value of one, the samples are clocked into register 78 with an extra five clock pulses to effect a division by 32. The maximum gain factor available from multiplier/divider $20'$ will be shown to be (2 x 27) or 54, which, when divided by 32, is 27/16. This factor adds one bit to the product, bringing the total number of bits in the product to (R+8). Thus, register 78 contains (R+8) bit positions and is clocked with a clock of R+13 pulses.

AND gates 68, 70 and 72 are disabled when $C_0$ and $C_1$ exhibit a logic low state. AND gates 72 and 70 couple the coarse product on input terminal 56 to subtracter 66 and adder 62 respectively when control signal C0 exhibits a logic high state. AND gates 72 and 68 couple the coarse product on input terminal 56 to subtracter 66 and adder 60 respectively whenever control $C_1$ exhibits a logic high state.

Consider $C_0$ and $C_1$ both to be exhibiting a logic low state. In this condition, the coarse product from terminal 56 is passed through the cascade connection of elements 58-66 delayed by five bit periods but otherwise unaltered, thus, the coarse product is multiplied by 32 (and subsequently divided by 32 when clocked into register 78).

Next, consider $C_0$ to be high and $C_1$ low. The coarse product is coupled to one input of adder 62 and the coarse product delayed by two bit periods (multiplied by four) is coupled to the other input of adder 62 through adder 60 and delay element 58. The internal sum of adder 62 is $(4+1)$ times the coarse product. This partial product is delayed two bit periods (multiplied by four) by the inherent delay in adder 62 and the delay of element 64 and coupled to the minuend input of subtracter 66. The coarse product is coupled to the subtrahend input of subtracter 66 which generates the difference of $[4(4+1)-1]$ times the coarse product or 19 times the coarse product. This sample undergoes one bit period delay in subtractor 66 which effectively doubles the product to 38 times the coarse product.

Now consider control signals C0 low and C1 high. In this condition the coarse product is coupled to one input of adder 60 via AND gate 68, and the coarse product delayed by one bit period (multiplied by 2) via delay element 58 is coupled to the other input of adder 60 which develops the sum $(2+1)$ times the coarse product. This sample undergoes a three sample bit period delay (multiplied by 8) in elements 60-64 and is coupled as the minuend to subtracter 66. The coarse product is coupled as subtrahend to subtracter 66 via AND gate 72. Subtracter 66 develops the difference of $[8(2+1)-1]$ times the coarse product or 23 times the coarse product. The inherent delay of subtracter 66 doubles this product to 46 times the coarse product.

Finally, when both C0 and C1 are high the coarse product is coupled to the subtrahend input of subtracter 66 and to inputs of adders 62 and 60. The output $(2+1)$ times the coarse product from adder 60 is delayed one bit period (multiplied by 2) and coupled to the second input of adder 62 which produces the sample $[2(2+1)+1]$ times the coarse product or 7 times the coarse product. This sample is delayed two sample bit periods (multiplied by 4) and coupled to the minuend input of subtracter 66 which develops the difference $(28-1)$ or 27 times the coarse product. This value is doubled by the inherent delay of subtracter 66 to a value of 54 times the coarse product.

Consider the control signal C4C3C2C1C0 formed by concatenating the signals C4, C3, C2, C1 and C0. This combination can represent $2^5$ or 32 states from 0-31. For the control signal C4C3C2C1C0 exhibiting the binary state 00000, the system exhibits 0 db gain. For this control signal exhibiting the binary state 11111, the system exhibits $20 \log_{10}(54/32) + 20 \log_{10}(128) = 46.69$ dB of gain. In between these extremes, if the binary value representing the control signal C4C3C2C1C0 is incremented in unit steps the gain factor changes in approximately 1.5dB steps.

In FIGURE 6, circuitry which may be implemented to generate such binary representative control signals C0-C4 includes a binary up/down counter having parallel binary output terminals $2^0$-$2^4$. These output terminals are connected to the control signal terminals C0-C4 respectively. The rate of volume control change should desirably be around three steps per second. The sample clock is divided down in divider 80 to generate an approximately 3Hz clock signal which is coupled to respective first input terminals of AND gates 82 and 84. AND gates 82 and 84 are selectively exclusively enabled by switches 87 and 88 respectively, to couple the 3Hz clock signal from divider 80 to either the up-clock input of an up/down counter 86 to increase system gain or to the down-clock input of the up/down counter to decrease system gain. It may also be desirable to have the divider 80 programmable so that the rate of volume control change can be controlled. One instance where a relatively fast rate of step changes may be utilized is in turning the audio system off. In this instance, the gain is rapidly reduced to a minimum prior to switching the system off to preclude a loud click or pop.

The system of FIGURE 6 may be slightly reconfigured to primarily provide signal attenuation. In this reconfiguration, register 78 is provided with R-bit positions or stages and is clocked with a clock signal having $(R+12)$ pulses per sample period. The resulting product resident in register 78 at the end of the sample period is equal to the product of the sample times the coarse and fine multiplying factors divided by $2^{12}$. Thus, for a concatenated control signal C4C3C2C1C0 represented by the binary value 00000 the gain factor is $2^5$ (the minimum gain of the fine gain multiplier/divider $20'$) times $2^{-12}$ which equals $2^{-7}$ or -42.14 db. The maximum gain provided by the system for the control signal C4C3C2C1C0 represented by the binary value 11111 is $2^7$ (maximum coarse gain) times $2(27)$ (maximum fine gain) times $2^{-12}$ or $+4.54$ dB.

It will be appreciated by those skilled in the art of digital signal processing that the shift registers 42 and 78 in the FIGURE 6 embodiments may be incorporated in, for example, the digital processor 14 and the DAC 22. In fact, register 42 may be totally eliminated depending on the source of samples provided to the volume control circuit. If it is not important to normalize the gain factors in the first embodiment described with reference to FIGURE 6, then the maximum gain of the system is 2 x 27 x 128 or 6912. The number of binary bits required to represent this factor is 13. Thus, register 78 will be configured with (R + 13) bit positions and will be clocked with bursts of (R + 13) clock pulses per sample period.

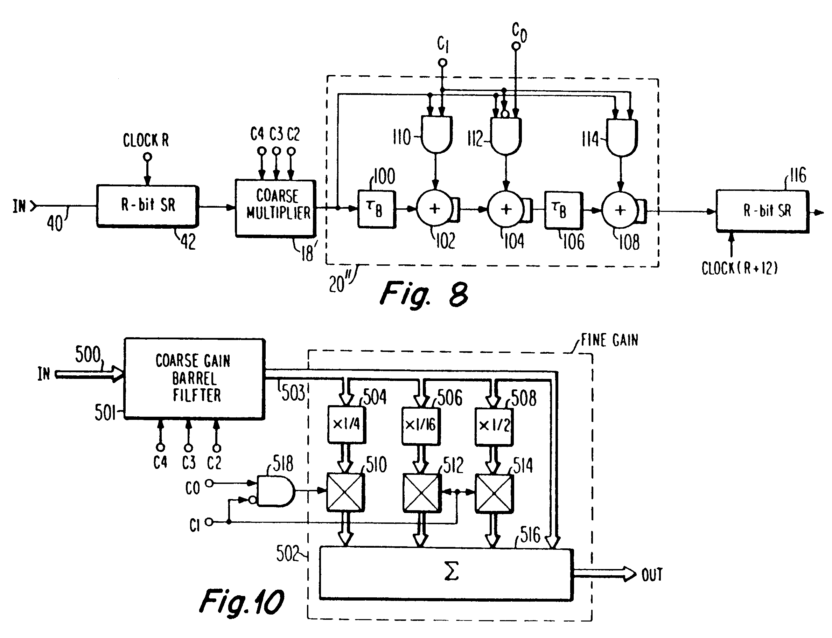

FIGURE 8 is a serial-bit digital volume control system which provides attenuation in approximately 2 db steps. Elements designated with like numerals to elements in FIGURE 2 are like elements. The fine multiplier/divider 20" is arranged to multiply the coarse product from the coarse multiplier/divider 18' by the factors 2(16), 2(20) and 2(25). The factor 2 in each of the gain factors results from the inherent delay provided by adder 108. The output of fine multiplier/divider 20" is coupled to an R-bit shift register clocked by bursts of (R + 12) clock pulses, thus, the FIGURE 8 system is configured to divide the products from element 18', 20" by $2^{-12}$.

Multiplier/divider 20" includes the cascade connection of delay element 100, adder 102, adder 104, delay element 106 and adder 108, each of which imposes a delay of one sample bit period. AND gate 110, controlled by control signal C1, couples the coarse product to a second input of adder 102 when control signal C1 is a logic high. AND gate 112, controlled by control signals C1 and C0, couples the coarse product to a second input terminal of adder 104 only on the condition that C1 is a logic low and C0 a logic high. AND gate 114, controlled by control signal C1, couples the coarse product to a second input terminal of adder 108 when C1 is a logic high.

For control signals, C0 and C1 both low, the coarse product passes through elements 100-108 delayed by five bit periods (multiplied by $2^5$) but is otherwise unaltered. The gain factor of the fine multiplier/divider 20" for the control signal C1C0 (control signals C1 and C0 concatenated) represented by the binary value 00 is 2(16) or 30.10 dB. If C0 is high and C1 low, i.e. C1C0 = 01, adder 104 is conditioned to sum the coarse product supplied via AND gate 112 with 4 times the coarse product supplied via adder 102 and delay element 100 and develop the sum of 5 times the coarse product. This sum is delayed 3-bit periods (multiplied by 8) in adder 104, delay element 106 and adder 108.

The value provided by adder 108 is (8 x 5) times the coarse product. Therefore, the fine gain for the control signal C1C0 represented by the binary value 01 is 32.04 dB which is 1.94 dB greater than for the control signal C1C0 represented by the binary value 00.

If C0 is low and C1 is high, adder 102 is conditioned to sum the coarse product coupled via AND gate 110 with twice the coarse product coupled via delay element 100, to provide the sum of 3 times the coarse product. This sum is delayed in adder 102, adder 104, delay element 106 (multiplied by 8) and summed with the coarse product in adder 108 to produce the sum of (24 + 1) times the coarse product. This sample is doubled by virtue of the delay in adder 108 to produce the product of 2(25) times the coarse product. Therefore, for the control signal C1C0 represented by the binary value 10, the fine gain factor is 50 or 33.99 dB which is 1.94 dB greater than for the control signal C1C0 represented by the binary value 01.

For control signals C1 and C0 both high, the gain factor remains the same as for C1 high and C0 low. Thus, for control signal C4C3C2 represented by the binary value 000 and control signal C1C0 represented by the binary values 00, 01, 10 and 11, the total system gain is -42.15 dB, -40.21 dB, -38.26 dB and -38.26 dB respectively, due to the division by $2^{12}$ effected by the extra 12 clock pulses applied to register 116. The maximum system gain occurs for the control signal C4C3C2C1C0 represented by the binary value 11111 and is -38.26 dB + $20\log2^7$ = 3.88 dB, and 0 dB gain occurs for the control signal C4C3C2C1C0 represented by the binary value 11100.

The control signals may be generated with apparatus similar to the apparatus illustrated in FIGURE 6. Alternatively, the control signals may be provided by, for example, a microprocessor used to control the audio reproduction system.

The multiplier/divider 20" is seen to change the gain/attenuation in approximately 2 dB steps for binary increments of the control signal C1C0. Similarly the total gain changes in 2 dB steps for binary increments of the control signal C4C3C2C1C0 represented in binary format if the states for control signal C1C0 equal to 11 are excluded.

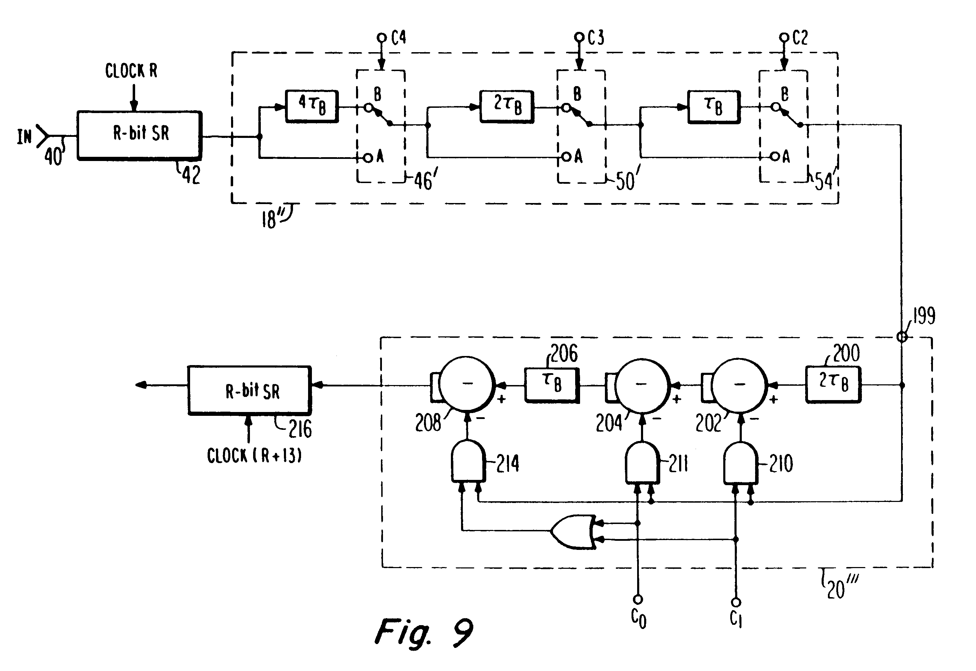

FIGURE 9 is an amplitude control system which provides attenuation in approximately 1.5 dB steps wherein the gain factor for the control signal C4C3C2C1C0 represented by the binary value 00000 is zero dB and the gain factor for the control signal C4C3C2C1C0 represented by the binary value 11111 is -42.14 dB. In FIGURE 9 the coarse multiplier/divider 18" is similar to the coarse multiplier/divider 18' shown in FIGURE 6 with the exception that for control signal values C4, C3 and C2 equal to logic zeroes the multiplexor 46', 50' and 54' couple their respective output terminals to their respective B input terminals. Thus, for the control signal C4C3C2 (formed by concatenating control signals C4, C3 and C2) represented by the binary values 000, 001, 010...111, the gain factors of the coarse multiplier/divider 18" are $2^7$, $2^6$, $2^5$ ...$2^0$ respectively.

The fine multiplier/divider 20''' is arranged to multiply samples applied thereto by the factors 64, 54, 46 and 38 for the control signal C1C0 (formed by concatenating control signals C1 and C0) represented by the binary values 00, 01, 10 and 11 respectively. This arrangement includes the cascade connection of a 2-sample bit delay element 200, a subtracter 202, a subtracter 204, a 1-sample bit delay element 206, and a third subtracter 208. The minuend input terminals of the subtracters are connected in the cascade connection. The subtrahend input terminal of subtracter 208 is coupled to the input terminal 199 of the fine multiplier/divider via AND gate 214 when either control signal CO or C1 is high. The subtrahend input terminal of subtracter 202 is coupled to input terminal 199 via AND gate 210 only when control signal C1 is high, and the subtrahend input terminal of subtracter 204 is coupled to input terminal 199 via AND gate 211 only when control signal C0 is high.

When both control signals C1 and C0 are low, samples applied to the fine multiplier/divider $20'''$ are delayed by 6 sample-bit periods but are otherwise unaltered. Thus, for the control signal C1C0 = 00, the gain factor of the fine multiplier/divider is 64 or $2^6$, and for the concatenated control signal C4C3C2C1C0 represented by the binary value 00000, the total gain of the coarse and fine multiplier/divider combination is $2^7$x64 or $2^{13}$. In order to normalize this gain factor to 1, that is 0 dB, the output of the fine multiplier/divider 216 is clocked in the R-bit shift register 216 with a clock having (R + 13) pulses per sample period. This effects a division by $2^{13}$. The maximum attenuation occurs when the control signal C4C3C2C1C0 is represented by the binary value 11111 which effects a coarse gain of $2^0$ times a fine gain of 38 divided by $2^{13}$ which is equal to $38$x$2^{-13}$ or -46.67 dB. Incrementally changing the concatenated control signals from 00000 to 11111 effects an attenuation of 46.67 dB in steps of approximately 1.5 dB.

FIGURE 10 is a parallel-bit embodiment of a volume control system for altering gain/attenuation in approximately 2 dB steps. Parallel-bit samples are coupled via bus 500 to the parallel-bit coarse gain/attenuation block 501. Block 501 may be a conventional barrel shifter which shifts the bit significance of the sample bits to effect multiplication/division by powers of 2. Barrel shifter 501 is controlled by a 3-bit control signal C4C3C2 and may provide gain/attenuation equal to $2^N$ where N is an integer ranging from 0-7 (decimal). Block 501 therefore provides gain/attenuation in 6 dB steps.

The output of coarse gain block 501 is coupled to a fine gain block 502. Fine gain block 502 includes weighting circuits 508, 504 and 506 which scale the signal provided from the coarse gain block by factors of 1/2, 1/4 and 1/16 respectively. Since the scale factors are reciprocal powers of 2, the weighting circuits may be simple hard-wired bit shift arrangements. The output samples from weighting circuits 508, 504 and 506 are respectively coupled to respective inputs of a parallel-bit summing circuit 516 by gating elements 514, 510 and 512. The output from the coarse gain block is also coupled to a respective input of summing circuit 516 via bus 503.

Gating elements 512 and 514 are controlled by control signal C1 and couple the respective weighted samples to summing circuit 516 when the control signal C1 is a logic high. Gating circuit 510 is controlled via AND gate 518 and couples weighted samples from the weighting circuit 504 to the summing circuit 516 only for the condition that control signal C0 is a logic high and control signal C1 a logic low.

When the control signal C1C0, formed by concatenating the control signals C1 and C0, is represented by the binary value 00, the only input sample coupled to the summing circuit 516 is the sample coupled directly from the coarse gain block. Consequently, the output sample from the summing circuit is equal to the input sample applied to the fine gain block, and the fine gain is 0 dB.

For the control signal C1C0 represented by the binary value 01, the input sample applied to the fine gain block and the input sample scaled by 1/4 from weighting circuit 504 is coupled to the summing circuit 516. The output sample from the summing circuit is equal to 5/4 times the input sample which represents a gain of 1.94 dB.

Finally, for the control signal C1C0 represented by the binary values 10 and/or 11, the input samples applied to the fine gain block and the input samples scaled by 1/16 and 1/2 from weighting circuits 506 and 508 are coupled to the summing circuit 516. The output produced by the summing circuit is 25/16 times the input sample, providing a gain from the fine gain block of 3.88 dB representing a 1.94 dB gain step over the gain developed for the control signal C1C0 represented by the binary value 01. Fine gain block 502 thus provides two gain values in increments of approximately 2 dB.

The Control signals C4, C3, C2, C1, C0 for the FIGURE 10 parallel bit embodiment, may be developed in the same manner as the control signals for the serial-bit embodiment illustrated in FIGURE 6.

In the claims which follow and which relate to serial-bit processing elements, the terms adder/delay and subtracter/delay are defined as elements which combine signals or samples and provide a delay of a sample bit period to the combined signal or sample.

## Claims

1. A bit-serial signal scaling apparatus (20') for scaling bit-serial signals by a constant factor characterized by:

means including a cascade connection of signal combining circuits (60,62,66) each in the form of an adder element (60,62) or a subtracter element (66), extending from a bit-serial signal input terminal, said signal combining circuits having respective first input terminals and output terminals coupled in said cascade connection wherein a delay (58,64) of at least one bit period is provided by or between ones of said signal combining circuits, said signal combining circuits having respective second input terminals; and

means (68,70,72,74) for selectively coupling said signal input terminal to said second input terminals of said signal combining circuits.

2. The bit-serial scaling apparatus set forth in claim 1 characterized in that said delay interposed between said signal combining circuits consists of the inherent processing delay of said signal combining circuits.

3. The bit-serial scaling apparatus set forth in claim 1 characterized in that said delay interposed between said signal combining circuits is provided by a plurality of signal delay circuits (58,64) each of which provides a delay of integral numbers, including one, of signal bit-periods, ones of said plurality of delay circuits being coupled between said ones of said signal combining circuits in said cascade connection.

4. The bit-serial scaling apparatus set forth in claim 1 characterized in that said delay interposed between said signal combining circuits consists of the inherent processing delay of said signal combining circuits, and bit-serial delay elements, having delays of integer numbers of bit periods, coupled between ones of said signal combining circuits in said cascade connection.

5. A digital signal amplitude control system for changing the amplitude value of a digital signal in substantially uniform dB steps, which steps are less than 6 dB, comprising the bit serial signal scaling apparatus set forth in claim 1, characterized by:

coarse control means $(18;18';18'')$, having a signal input terminal and having control signal input terminals and an output terminal, including means for altering the amplitude value of digital signals in multiples, including one, of 6 dB steps responsive to first control signals applied to said control signal input terminals;

fine control means $(20;20';20'';20''')$ comprising said cascade connection of signal combining circuits and having a signal input terminal, an output terminal and control signal input terminals, with means (58,60,62,64,66,68,70,72,74) for multiplying digital signals by a number of predetermined values responsive to second control signals applied to its control signal input terminals, wherein an ordered ascending/descending sequence of said predetermined values is substantially logarithmic;

means (56;199) for coupling said coarse control means and said fine control means in a serial combination receptive of said digital signal: and

control signal generating means (80,82,84,86,87,88), for generating said first and second control signals, wherein successive changes of said first and second control signals effect amplitude changes, in signal processed by said serial combinaton of coarse and fine control means, in substantially uniform increments of dB, which increments are less than 6 dB.

6. The system set forth in Claim 5 wherein said means for multiplying multiplies digital signals by a predetermined number, P, of predetermined values responsive to second control signals applied to its control signal input terminals, characterized in that P is an integer, and 20 times the logarithm (base 10) of the ratio of successive ones of an ordered ascending sequence of said predetermined values is substantially equal to six divided by P.

7. The system set forth in Claim 6 characterized in that said means for multiplying digital signals multiplies said signals by four predetermined values and said predetermined values include one of the sequence 16, 19, 23, 27 and the sequence k16, k19, k23, k27, where k is a scaler constant.

8. The system set forth in Claim 6 characterized in that said control signal generating means generates multibit binary values, the lesser significant bits of which are coupled to said fine control means as said second control signals and the more significant bits of which are coupled to said coarse control means as said first control signals, and includes means for incrementing said binary values in unit steps.

**9.** The system set forth in Claim 6 characterized in that said means for multiplying digital signals multiplies said signals by three predetermined values and said predetermined values include one of the sequence 16, 20, 25, and the sequence k16, k20, k25, where k is a scaler constant.

**10.** The system set forth in Claim 5 characterized in that said digital signal is a serial-bit digital signal said serial-bit digital signal occurring as PCM samples with LSB's occurring first in time;

said course control means including a coarse multiplier/divider having (44,46,48,50,52,54) signal input and output terminals, and having control input terminals for applying an N-state control signal (N being an integer), said coarse multiplier/divider responsive to said control signal for selectively delaying a serial-bit PCM signal by K sample bit periods, K being an integer from 0 to (N-1) inclusive;

said fine control means including a fine multiplier/divider (58,60,62,64,66,68,70,72,74) having signal input and output terminals, and having control input terminals for applying an M-state control signal (M being an integer), including means responsive to said control signal for selectively combining signals applied to the signal input terminal of said fine multiplier/divider which are relatively delayed by integral sample bit periods to effect multiplication of serial-bit signals by predetermined values;

said first and second control signals generated by said control signal generating means, are said M-state and said N-state control signals respectively.

**11.** The system set forth in Claim 10 characterized in that said fine multiplier/divider comprises:

a cascade connection of adder/delay (60,62) and delay elements (58,64), having an output terminal and having an input terminal corresponding to the signal input terminal of said fine multiplier/divider, and wherein said adder/delay elements have respective first input terminals connected in said cascade connection and have respective second input terminals;

gating means (68,70,72,74) having control input terminals corresponding to said control input terminals for applying an M-state control signal, said gating means including means for selectively coupling the input terminal of said cascade connection to respective ones of said second input terminals.

**12.** The system set forth in Claim 11 characterized in that said cascade connection comprises, in order from input terminal to output terminal,

a delay element, (58)
an adder/delay element (60)
a further adder/delay element (62)
a further delay element (64)
a subtracter/delay element (66),
said subtracter/delay element having a minuend input terminal connected in cascade and having a subtrahend input terminal;

and wherein said fine multiplier/divider includes further gating means responsive to said M-state control signals for selectively coupling said subtrahend input terminal to the input terminal of said cascade connection.

**13.** The system set forth in Claim 10 characterized in that said fine multiplier/divider comprises:

a cascade connection of subtracter/delay elements (202,204,208) and delay elements (200,206), having an output terminal and having an input terminal corresponding to the signal input terminal of said fine multiplier/divider, said subtracter delay elements have respective first input terminals connected in said cascade connection and have respective second input terminals; and

gating means (210,211,214), having control input terminals corresponding to said control input terminals for applying an M-state control signal, including means for selectively coupling the input terminal of said cascade connection to ones of said second input terminals.

**14.** The system set forth in Claim 13 characterized in that said cascade connection comprises, in order from input terminal to output terminal:

a delay element (200);
a first subtracter/delay element (202);
a second subtracter/delay element (204);
a further delay element (206); and
a third subtracter/delay element (208).

**15.** The system set forth in Claim 14 characterized in that said first (202), second (204) and third (208) subtracter/delay elements have respective minuend input terminals connected in the cascade connection and said delay element (200) and further delay element (206) provide delay periods in the ratio 2:1.

**Patentansprüche**

**1.** Bit-serielle Signal-Skalierungsvorrichtung (20') zur Skalierung bit-serieller Signale mit einem konstanten Faktor,
gekennzeichnet durch:
Mittel, die eine Kaskadenschaltung von Signalkombinationsschaltungen (60, 62, 66) jeweils in Form eines Additionselements (60, 62) oder eines Subtraktionselements (66) enthalten, die von einem bit-seriellen Signaleingangsanschluß ausgehen, wobei die Signalkombinationsschaltungen jeweils erste Eingangsanschlüsse und Ausgangsanschlüsse in der Kaskadenschaltung aufweisen, wobei eine Verzögerung (58, 64) von wenigstens einer Bitperiode durch einzelne oder zwischen einzelnen Signalkombinationsschaltungen vorgesehen ist, und wobei die Signalkombinationsschaltungen jeweils zweite Eingangsanschlüsse aufweisen; und
Mittel (68, 70, 72, 74) zur wahlweisen Verbindung des Signalseingangsanschlusses mit den zweiten Eingangsanschlüssen der Signalkombinationsschaltungen.

**2.** Bit-serielle Skalierungsvorrichtung nach Anspruch 1,
dadurch gekennzeichnet, daß die zwischen den Signalkombinationsschaltungen eingeschaltete Verzögerung aus der den Signalkombinationsschaltungen von Natur anhaftenden Verarbeitungsverzögerung besteht.

**3.** Bit-serielle Skalierungsvorrichtung nach Anspruch 1,
dadurch gekennzeichnet, daß die zwischen den Signalkombinationsschaltungen eingeschaltete Verzögerung durch eine Vielzahl von Signalverzögerungsschaltungen (58, 64) bewirkt wird, von denen jede eine Verzögerung von ganzen Zahlen von Signal-Bitperioden einschließlich einer Bitperiode vorsieht, wobei einzelne aus der Vielzahl von Verzögerungsschaltungen zwischen einzelnen Signalkombinationsschaltungen in der Kaskadenschaltung angeschlossen sind.

**4.** Bit-serielle Skalierungsvorrichtung nach Anspruch 1,
dadurch gekennzeichnet, daß die zwischen den Signalkombinationsschaltungen eingeschalte Verzögerung aus der den Signalkombinationsschaltungen von Natur anhaftenden Verarbeitungsverzögerung und bit-seriellen Verzögerungselementen mit Verzögerungen von ganzen Zahlen von Bitperioden besteht, die zwischen einzelnen Signalkombinationsschaltungen in der Kaskadenschaltung angeschlossen sind.

**5.** Digitales Signalamplituden-Steuerungssystem zur Änderung des Amplitudenwertes einen digitalen Signals in weitgehend gleichmäßigen dB-Schritten, die kleiner als 6 dB sind, umfassend die bit-serielle Signal-Skalierungsvorrichtung nach Anspruch 1,
gekennzeichnet durch:
Grobsteuermittel (18; 18'; 18'') mit einem Signaleingangsanschluß und Steuersignal-Eingangsanschlüssen sowie einem Ausgangsanschluß, einschließlich Mitteln, die auf den Steuersignal-Eingangsanschlüssen zugeführte erste Steuersignale ansprechen, um den Amplitudenwert von digitalen Signalen in vielfachen 6 dB-Schritten einschließlich einem Schritt zu ändern;
Feinsteuermittel (20; 20'; 20''; 20'''), die die Kaskadenschaltung von Signalkombinationsschaltungen umfassen und einen Signaleingangsanschluß, einen Ausgangsanschluß und Steuersignal-Eingangsanschlüsse haben sowie Mittel (58, 60, 62, 64, 66, 68, 70, 72, 74) aufweisen, die auf ihren Steuersignal-Eingangsanschlüssen zugeführte zweite Steuersignale ansprechen, um digitale Signale mit einer Anzahl von vorgegebenen Werten zu multiplizieren, wobei eine geordnete aufsteigende/absteigende Sequenz der vorgegebenen Werte im wesentlichen logarithmisch ist;
Mittel (56; 199) zur Verbindung der Grobsteuermittel mit den Feinsteuermitteln in einer Reihenkombination für den Empfang des digitalen Signals; und
Steuersignal-Erzeugungsmittel (80, 82, 84, 86, 87, 88) zur Erzeugung des ersten und zweiten Steuersignals, wobei aufeinanderfolgende Änderungen des ersten und zweiten Steuersignals Amplitudenänderungen in dem von der Reihenkombination aus Grob- und Feinsteuermitteln verarbeiteten Signal in weitgehend gleichmäßigen dB-Schritten bewirken, die kleiner als 6 dB sind.

14

**6.** System nach Anspruch 5, bei dem die Mittel zum Multiplizieren, ansprechend auf den Steuersignal-Eingangsanschlüssen zugeführte zweite Steuersignale, digitale Signale mit einer vorgegebenen Anzahl P von vorgegebenen werten multiplizieren, dadurch gekennzeichnet, daß P eine ganze Zahl ist und das 20-Fache des Logarithmus (Basis 10) des Verhältnisses von aufeinanderfolgenden Werten einer geordneten ansteigenden Sequenz der vorgegebenen Werte etwa 6 geteilt durch P ist.

**7.** System nach Anspruch 6, dadurch gekennzeichnet, daß die Mittel zum Multiplizieren digitaler Signale die Signale mit vier vorgegebenen Werten multiplizieren und die vorgegebenen Werte einen aus der Sequenz 16, 19, 23, 27 und der Sequenz k16, k19, k23, k27 einschließen, wobei k eine Skalierungskonstante ist.

**8.** System nach Anspruch 6, dadurch gekennzeichnet, daß die Steuersignal-Erzeugungsmittel Multibit-Binärwerte erzeugen, von denen die weniger bedeutsamen Bits (LSB's) den Feinsteuermitteln als die zweiten Steuersignale und die bedeutsameren Bits den Grobsteuermitteln als die ersten Steuersignale zugeführt werden, und Mittel enthalten, um die Binärwerte in Einheitsschritten fortzuschalten.

**9.** System nach Anspruch 6, dadurch gekennzeichnet, daß die Mittel zum Multiplizieren digitaler Signale die Signale mit drei vorgegebenen Werten multiplizieren und die vorgegebenen Werte einen aus der Sequenz 16, 20, 25 und der Sequenz k16, k20, k25 einschließen, wobei k eine Skalierungskonstante ist.

**10.** System nach Anspruch 5, dadurch gekennzeichnet, daß das digitale Signal ein digitales Seriellbitsignal ist, das in Form von PCM-Abtastungen mit LSB's auftritt, die zeitlich zuerst auftreten;

daß die Grobsteuermittel einen Grob-Multiplizierer/Teiler (44, 46, 48, 50, 52, 54) enthalten, der Signaleingangs- und -ausgangsanschlüsse sowie Steuer-Eingangsanschlüsse zur Zuführung eines N-Zustands-Steuersignals hat (wobei N eine ganze Zahl ist), wobei der Grob-Multiplizierer/Teiler auf das Steuersignal anspricht, um wahlweise ein Seriell-Bit-PCM-Signal um K Abtast-Bitperioden zu verzögern, wobei K eine ganze Zahl von Null bis (N-1) einschließlich ist;

daß die Feinsteuermittel einen Fein-Multiplizierer/Teiler (58, 60, 62, 64, 66, 68, 70, 72, 74) enthalten, der Signaleingangs- und -ausgangsanschlüsse sowie Steuer-Eingangsanschlüsse zur Zuführung eines M-Zustands-Steuersignals hat, (wobei M eine ganze Zahl ist), wobei Mittel vorgesehen sind, die auf das Steuersignal ansprechen, um wahlweise Signale zu kombinieren, die dem Signal-Eingangsanschluß des Fein-Multiplizierers/Teilers zugeführt werden, die relativ durch ganzzahlige Abtast-Bitperioden verzögert sind, um eine Multiplikation von seriellen Bitsignalen mit vorgegebenen Werten zu bewirken;

daß das erste und zweite von den Steuersignal-Erzeugungsmitteln erzeugte Steuersignal das M-Zustands- bzw. das N-Zustands-Steuersignal ist.

**11.** System nach Anspruch 10, dadurch gekennzeichnet, daß der Fein-Multiplizierer/Teiler umfaßt:

eine Kaskadenschaltung einer Additions/Verzögerungsschaltung (60, 62) und Verzögerungselemente (54, 64), die einen Ausgangsanschluß und einen Eingangsanschluß entsprechend dem Signaleingangsanschluß des Fein-Multiplizierers/Teilers haben, und wobei die Additions/Verzögerungselemente entsprechende erste Eingangsanschlüsse haben, die in der Kaskadenschaltung angeschlossen sind und entsprechende zweite Eingangsanschlüsse haben;

Gatterschaltungen (68, 70, 72, 74) mit Steuereingangsanschlüssen, die den Steuereingangsanschlüssen zur Zuführung eines M-Zustands-Steuersignals entsprechen, wobei die Gattermittel Mittel enthalten, um wahlweise den Eingangsanschluß der Kaskadenschaltung mit den entsprechenden zweiten Eingangsanschlüssen zu verbinden.

**12.** System nach Anspruch 11, dadurch gekennzeichnet, daß die Kaskadenschaltung in der Reihenfolge vom Eingangsanschluß bis zum Ausgangsanschluß umfaßt:

ein Verzögerungselement (58)

ein Additions/Verzögerungselement (60)

ein weiteres Additions/Verzögerungselement (62)

ein weiteres Verzögerungselement (64)

ein Subtraktions/Verzögerungselement (66)

wobei das Subtraktions/Verzögerungselement einen in Kaskade geschalteten Minuend-Eingangsanschluß und einen Subtrahend-Eingangsanschluß hat;

und wobei der Fein-Multiplizierer/Teiler weitere Gatterschaltungen einschließt, die auf die M-Zustands-Steuersignale ansprechen, um wahlweise den Subtrahend-Eingangsanschluß mit dem Eingangsanschluß der Kaskadenschaltung zu verbinden.

**13.** System nach Anspruch 10, <u>dadurch gekennzeichnet,</u> daß der Fein-Multiplizierer/Teiler umfaßt:

eine Kaskadenschaltung aus Subtraktions/Verzögerungselementen (202, 204, 208) und Verzögerungselementen (200, 206) die einen Eingangsanschluß und einen Ausgangsanschluß entsprechend dem Signaleingangsanschluß des Fein-Multiplizierers/Teilers hat, wobei die Subtraktions/Verzögerungselemente jeweils in der Kaskadenschaltung angeschlossene erste Eingangsanschlüsse sowie jeweils zweite Eingangsanschlüsse haben; und

Gatterschaltungen (210, 211, 214) mit Steuereingangsanschlüssen entsprechend den Steuereingangsanschlüssen zur Zuführung eines M-Zustands-Steuersignals einschließlich Mitteln zur wahlweisen Verbindung des Eingangsanschlusses der Kaskadenschaltung mit einzelnen zweiten Eingangsanschlüssen.

**14.** System nach Anspruch 13, <u>dadurch gekennzeichnet,</u> daß die Kaskadenschaltung in der Reihenfolge vom Eingangsanschluß zum Ausgangsanschluß umfaßt:

ein Verzögerungselement (200);
ein erstes Subtraktions/Verzögerungselement (202);
ein zweites Subtraktions/Verzögerungselement (204);
ein weiteres Verzögerungselement (206); und
ein drittes Subtraktions/Verzögerungselement (208).

**15.** System nach Anspruch 14 <u>dadurch gekennzeichnet,</u> daß das erste (202), das zweite (204) und das dritte (208) Subtraktions/Verzögerungselement entsprechende in der Kaskadenschaltung angeschlossene Minuend-Eingangsanschlüsse haben und das Verzögerungselement (200) und das weitere Verzögerungselement (206) Verzögerungsperioden im Verhältnis 2:1 haben.

**Revendications**

**1.** Dispositif de conversion d'échelle d'un signal à binaires en série (20') pour convertir les signaux à binaires en série par un facteur constant,
caractérisé par :
un moyen comprenant un montage en cascade de circuits de combinaison de signaux (60, 62, 66) chacun sous la forme d'un élément additionneur (60,62) ou d'un élément soustracteur (66) s'étendant à partir d'une borne d'entrée du signal à binaires en série, lesdits circuits de combinaison de signaux comportant des premières bornes respectives d'entrée et des bornes de sortie couplées dans ledit montage en cascade dans lequel un retard (58, 64) d'au moins une période d'un binaire est fourni par ou entre les circuits desdits circuits de combinaison de signaux, lesdits circuits de combinaison de signaux comportant des secondes bornes respectives d'entrée ; et
un moyen (68, 70, 72, 74) pour coupler sélectivement ladite borne d'entrée de signaux auxdites secondes bornes d'entrée desdits circuits de combinaison de signaux.

**2.** Dispositif de conversion d'échelle de binaires en série selon la revendication 1, caractérisé en ce que ledit retard interposé entre lesdits circuits de combinaison de signaux correspond au retrad inhérent de traitement desdits circuits de combinaison des signaux.

**3.** Dispositif de conversion d'échelle de binaires en série selon la revendication 1, caractérisé en ce que ledit retard interposé entre lesdits circuits de combinaison de signaux est fourni par une pluralité de circuits à retard de signaux (58, 64) dont chacun fournit un retard de nombres entiers, incluant un, de périodes de binaires des signaux, quelques uns de ladite pluralité des circuits à retard étant couplés entre lesdits circuits desdits circuits de combinaison de signaux dudit montage en cascade.

**4.** Dispositif de conversion d'échelle de binaires en série selon la revendication 1 caractérisé en ce que ledit retard interposé entre lesdits circuits de combinaison de signaux comprend le retard inhérent au traitement desdits circuits de combinaison de signaux et les éléments à retard de binaires en série, comportant des retards de nombres entiers de périodes de binaire, couplés entre les circuits desdits circuits de combinaison des signaux dans ledit montage en cascade.

**5.** Système de contrôle d'amplitude de signaux numériques pour modifier la valeur de l'amplitude d'un signal numérique par étapes en dB sensiblement uniformes, lesquelles étapes sont inférieures à 6 dB comprenant le dispositif de conversion d'échelle d'un signal de binaires en série établi selon la revendication 1, caractérisé par :

un moyen de contrôle grossier (18; 18'; 18") comportant une borne d'entrée de signaux et comportant des bornes d'entrée de signaux de contrôle et une borne de sortie, incluant des moyens pour modifier la valeur d'amplitude des signaux numériques de multiples, un étant inclus, pas de 6 dB sensibles aux premiers signaux de contrôle appliqués auxdites bornes d'entrée de signaux de contrôle ;

un moyen de contrôle fin (20; 20';20";20''') comprenant ledit montage en cascade des circuits de combinaison de signaux et comportant une borne d'entrée de signaux, une borne de sortie et des bornes d'entrée de signaux de contrôle , avec les moyens (58,60,62,64,66,68,70,72,74) pour multiplier les signaux numériques par un nombre de valeurs prédéterminées sensibles aux seconds signaux de contrôle appliqués à ses bornes d'entrée de signaux de contrôle, dans lequel une séquence ordonnée croissante/décroissante desdites valeurs prédéterminées est essentiellement logarithmique;

un moyen (56;199) pour coupler ledit moyen de contrôle grossier et ledit moyen de contrôle fin dans une combinaison série réceptrice dudit signal numérique ; et

un moyen de générer un signal de contrôle (80,82,84,86,87,88) pour générer lesdits premier et second signaux de contrôle, dans lequel les variations successives desdits premier et second signaux de contrôle effectuent des variations d'amplitude, dans le signal traité par ladite combinaison série des moyens de contrôle grossier et fin, selon des incréments en dB sensiblement uniformes, incréments qui sont inférieurs à 6 dB.

**6.** Système selon la revendication 5 dans lequel ledit moyen de multiplication multiplie les signaux numériques par un nombre prédéterminé, P, de valeurs prédéterminées sensibles aux seconds signaux de commande appliqués à ses bornes d'entrée de signaux de contrôle, caractérisé en ce que P est un entier et 20 fois le logarithme (base 10) du rapport des valeurs successives d'une séquence ordonnée croissante auxdites valeurs prédéterminées est sensiblement égal à six divisé par P.

**7.** Système selon la revendication 6 caractérisé en ce que ledit moyen pour multiplier les signaux numériques multiplie lesdits signaux par quatre valeurs prédéterminées et lesdites valeurs prédéterminées incluent une valeur de la séquence 16,19,23, 27 et de la séquence k16, k19, k23, k27 où k est une constante de conversion.

**8.** Système selon la revendication 6 caractérisé en ce que ledit moyen de générer des signaux de contrôle génère les valeurs binaires à plusieurs bits dont les binaires les moins significatifs sont couplés audit moyen de contrôle fin comme lesdits seconds signaux de contrôle et dont les binaires les plus significatifs sont couplés audit moyen de contrôle grossier comme lesdits premiers signaux de contrôle et inclut un moyen pour incrémenter lesdites valeurs binaires par pas unitaires.

**9.** Système selon la revendication 6 caractérisé en ce que ledit moyen pour multiplier les signaux numériques multiplie lesdits signaux par trois valeurs prédéterminées et lesdites valeurs prédéterminées incluent une valeur de la séquence 16, 20, 25 et de la séquence k16, k20, k25 où k est une constante de conversion;

**10.** Système selon la revendication 5 caractérisé en ce que ledit signal numérique est un signal numérique à binaires en série, ledit signal numérique à binaires en série se produisant comme les échantillons MIC de modulation par impulsions codées avec les LSB (bits les moins significatifs) se produisant en premier dans le temps ;

ledit moyen de contrôle grossier incluant un multiplicateur /diviseur grossier comportant des bornes d'entrée et de sortie de signaux (44, 46, 48, 50, 52, 54) et comportant des bornes d'entrée de commande pour appliquer un signal de contrôle à N états (N étant un entier), ledit multiplicateur/diviseur grossier étant sensible audit signal de contrôle pour retarder sélectivement un signal MIC à binaires en série de K périodes de binaires d'échantillon, K étant un entier de 0 à (N-1) inclus ;

ledit moyen de contrôle fin incluant un multiplicateur/diviseur fin (58,60,62,64,66,68,70,72, 74) comportant des bornes d'entrée et de sortie des signaux et comportant des bornes d'entrée de commande pour appliquer un signal de contrôle à M états (M étant un entier), comprenant un moyen sensible audit signal de contrôle pour combiner sélectivement les signaux appliqués à la borne d'entrée de signaux dudit multiplicateur/diviseur fin, qui sont relativement retardés de périodes entières de binaires d'échantillon pour effectuer une multiplication des signaux à binaires en série par des valeurs prédéterminées;

lesdits premier et second signaux de contrôle générés par ledit moyen de production de signaux de contrôle sont respectivement lesdits signaux de contrôle à M états et à N états.

**11.** Système selon la revendication 10 caractérisé en ce que ledit multiplicateur/diviseur fin comprend :

un montage en cascade d'éléments à retard/additionneurs (60,62) et d'éléments à retard (58,64) comportant une borne de sortie et comportant une borne d'entrée correspondant à la borne d'entrée de signaux dudit multiplicateur/diviseur fin et dans lequel lesdits éléments à retard additionneurs ont des premières bornes respectives d'entrée connectées dans ledit montage en cascade et possèdent des secondes bornes respectives d'entrée ;

des moyens de porte (68, 70, 72, 74) comportant des bornes d'entrée de commande correspondant auxdites bornes d'entrée de commande pour appliquer un signal de contrôle à M états, lesdits moyens de porte incluant un moyen pour coupler sélectivement la borne d'entrée dudit montage en cascade aux bornes respectives desdites secondes bornes d'entrée.

**12.** Système selon la revendication 11, caractérisé en ce que ledit montage en cascade comprend dans l'ordre, de la borne d'entrée à la borne de sortie

un élément à retard (58)

un élément à retard /additionneur (60)

un élément à retard/additionneur supplémentaire (62)

un élément à retard supplémentaire (64)

un élément à retard/soustracteur (66)

ledit élément à retard/soustracteur comportant une borne d'entrée du diminuende connectée en cascade et comportant une borne d'entrée du diminuteur ;

et dans lequel ledit multiplicateur/diviseur fin inclut un moyen de porte supplémentaire sensible auxdits signaux de contrôle à M états pour coupler sélectivement ladite borne d'entrée du diminuteur à la borne d'entrée dudit montage en cascade.

**13.** Système selon la revendication 10 caractérisé en ce que ledit multiplicateur/diviseur fin comprend :

un montage en cascade d'éléments à retard/soustracteurs (202, 204, 208) et d'éléments à retard (200, 206) comportant une borne de sortie et comportant une borne d'entrée correspondant à la borne d'entrée de signaux dudit multiplicateur/diviseur fin, lesdits éléments à retard/soustracteurs possédant des premières bornes respectives d'entrée connectées dans ledit montage en cascade et possédant des secondes bornes respectives d'entrée ; et

des moyens de porte (210, 211, 214) comportant des bornes d'entrée de commande correspondant auxdites bornes d'entrée de commande pour appliquer un signal de contrôle à M états, incluant un moyen pour coupler sélectivement la borne d'entrée dudit montage en cascade aux bornes desdites secondes bornes d'entrée .

**14.** Système selon la revendication 13 caractérisé en ce que ledit montage en cascade comprend dans l'ordre, de la borne d'entrée à la borne de sortie:

un élément à retard (200) ;

un premier élément à retard soustracteur (202);

un second élément à retard/soustracteur (204);

un autre élément à retard (206) ; et

un troisième élément à retard/soustracteur (208);

**15.** Système selon la revendication 14 caractérisé en ce que lesdits premier (202), second (204) et troisième (208) éléments à retard/soustracteurs possèdent des bornes respectives d'entrée du diminuende connectées dans le montage en cascade et ledit élément à retard (200) et l'autre élément à retard (206) fournissent des retards dans le rapport 2:1.

EP 0 261 954 B1

*Fig.1*

*Fig.3*

Fig. 2

EP 0 261 954 B1

Fig. 4

Fig. 5

EP 0 261 954 B1

*Fig. 6*

*Fig. 7*

EP 0 261 954 B1

*Fig. 8*

*Fig. 10*

25

Fig. 9

EP 0 261 954 B1